**Europäisches Patentamt**

**European Patent Office**

**Office européen des brevets**

(11) Numéro de publication : **0 477 087 A1**

## (12) DEMANDE DE BREVET EUROPEEN

(21) Numéro de dépôt : **91402466.6**

(22) Date de dépôt : **17.09.91**

(51) Int. Cl.$^5$ : **G01R 29/08,** G01R 15/10

(30) Priorité : **21.09.90 FR 9011679**

(43) Date de publication de la demande :
**25.03.92 Bulletin 92/13**

(84) Etats contractants désignés :
**CH DE GB IT LI NL SE**

(71) Demandeur : **THOMSON-CSF**
**51, Esplanade du Général de Gaulle**
**F-92800 Puteaux (FR)**

(72) Inventeur : **Eumurian, Grégoire**
**THOMSON-CSF, SCPI, Cédex 67**
**F-92045 Paris la Défense (FR)**

(74) Mandataire : **Benoit, Monique**
**THOMSON-CSF SCPI**
**F-92045 PARIS LA DEFENSE CEDEX 67 (FR)**

(54) **Dispositif de traitement d'un signal provenant d'un capteur ayant une réponse du type dérivatif.**

(57)    Le domaine de l'invention est celui des dispositifs de mesure de signaux dans le domaine des phénomènes large bande.

Plus précisément, la présente invention concerne un dispositif de traitement d'un signal électrique provenant d'un capteur (10) du type dérivatif destiné à mesurer un champ électrique ou magnétique, des courants de charge de surface ou autres grandeurs dérivées, ledit traitement incluant le calcul de la primitive de la partie dudit signal de fréquence spectrale supérieure à une fréquence basse $f_1$ , ledit dispositif comprenant :

— des moyens (20) d'intégration électronique dudit signal, à partir d'une fréquence $f_2$ supérieure à ladite fréquence basse $f_1$ ;

— des moyens (21) de compensation amplifiant et intégrant ledit signal entre les fréquences $f_1$ et $f_2$.

Fig. 2

Le domaine de l'invention est celui des dispositifs de mesure de signaux dans le domaine des phénomènes large bande.

Plus précisément, la présente invention concerne un dispositif de traitement de signaux provenant notamment de capteurs d'impulsions électromagnétiques nucléaires (IEM), de foudre ou de compatibilité électromagnétique (CEM). De tels capteurs peuvent consister en des capteurs large bande de champs électriques, magnétiques, de courants ou de charges de surface, présentant une réponse en fréquence s'étendant depuis 10 à 100 kHz environ jusqu'à plus de 1 GHz.

De façon connue, ces capteurs peuvent être soit des capteurs passifs, soit des capteurs actifs.

Les capteurs passifs utilisent des éléments de captation branchés sur une charge de basse impédance, valant par exemple 50 $\Omega$.

La liaison entre le capteur et la charge est habituellement réalisée par un câble de même impédance. Le principe de fonctionnement de capteurs passifs est par exemple décrit dans l'article " Sensors for electromagnetic pulse measurements both inside and away from nuclear source regions" ("Capteurs pour la mesure d'impulsions électromagnétiques simultanément à l'intérieur et éloignés de sources nucléaires"), (Carl BAUM, Edward BREEN, Joseph GILLES, John O'NEILL, Gary SOWER, IEEE TRANSACTIONS ON ANTENNAS AND PROPAGATION, Vol. AP-26, n° 1, janvier 1978).

De tel capteurs passifs présentent une réponse dérivative qui nécessite un traitement pour obtenir la forme réelle du signal à mesurer. Le traitement consiste à intégrer le signal provenant du capteur, par exemple à l'aide d'une cellule RC, et à amplifier le signal intégré grâce à un amplificateur d'impédance d'entrée supérieure à l'impédance équivalente de l'intégrateur.

Le principal avantage des capteurs passifs est qu'ils permettent le passage de fréquences élevées, pouvant aller jusqu'à 10 GHz. De plus, les capteurs passifs sont simples à réaliser. Cependant, de tels capteurs présentent l'inconvénient d'être de sensibilité réduite.

Les capteurs actifs, en revanche, présentent une sensibilité de mesure de champ magnétique et de champ électrique respectivement jusqu'à 100 et 3000 fois plus importante que les capteurs passifs.

De tels capteurs actifs sont par exemple décrits dans le document "Computer-assisted control of EMP measurement on major systems" ("Commande assistée par ordinateur pour la mesure d'impulsions électromagnétiques sur des systèmes principaux"), Grégoire EUMURIAN, Proceedings of the 6th symposium on Electromagnetic Compatibility, Zurich 1985.

Le traitement de signaux provenant d'un capteur actif mesurant des champs électriques est assuré par un amplificateur à très haute impédance (>1 M$\Omega$), et par une bobine haute impédance à noyau magnétique pour un capteur actif de champ magnétique.

Les capteurs actifs conviennent bien pour des applications jusqu'à 200 à 300 MHz, mais leur électronique interne devient délicate à réaliser au-delà.

Par ailleurs, cette électronique conduit à des capteurs plus encombrants ce qui est contradictoire avec la montée en fréquence et donc la diminution de la longueur d'onde.

La présente invention a notamment pour objectif de pallier les inconvénients des dispositifs existants.

Plus précisément, un premier objectif de la présente invention est de fournir un dispositif de traitement d'informations délivrées par un capteur passif large bande, notamment destiné à détecter un champ électrique, magnétique, un courant ou une charge de surface, permettant d'obtenir une sensibilité comparable à celle des capteurs actifs, tout en préservant la bande passante du capteur passif.

Un objectif complémentaire de la présente invention est qu'un tel dispositif soit simple à réaliser et présente un faible bruit.

Ces objectifs, ainsi que d'autres qui apparaîtront par la suite, sont atteints grâce à un dispositif de traitement d'un signal électrique provenant d'un capteur du type dérivatif destiné à mesurer un champ électrique ou magnétique, des courants ou charge de surface ou autres grandeurs dérivées, ledit traitement incluant le calcul de la primitive de la partie spectrale dudit signal de fréquence supérieure à une fréquence basse $f_1$ , le dispositif comprenant:

- des moyens d'intégration électronique dudit signal, à partir d'une fréquence $f_2$ supérieure à ladite fréquence basse $f_1$ ;
- des moyens de compensation amplifiant et intégrant ledit signal entre les fréquences $f_1$ et $f_2$.

Préférentiellement, lesdits moyens de compensation sont montés en ligne et en aval desdits moyens d'intégration.

Avantageusement, lesdits moyens de compensation présentent une pente d'intégration égale à celle desdits moyens d'intégration.

Préférentiellement, lesdites pentes d'intégration sont de -6dB/octave.

Selon un mode de réalisation préférentiel, lesdits moyens d'intégration sont constitués chacun par au moins une cellule RC.

Avantageusement, le dispositif comprend également un filtre passe-haut dans ladite chaîne de traitement, de fréquence de coupure $f_0$ inférieure à $f_1$.

De préférence, la pente de la caractéristique de transfert dudit filtre passe-haut est de + 6dB/octave.

Selon un mode de réalisation préférentiel de la présente invention, ladite fréquence basse $f_1$ est de l'ordre de 100 kHz et ladite fréquence $f_2$ de l'ordre de 10 MHz.

Avantageusement, lesdits moyens de compensation comprennent au moins un amplificateur large bande et/ou au moins un transistor.

Le dispositif selon l'invention est de préférence utilisé pour le traitement de signaux provenant d'un capteur de champ électrique, de champ magnétique, de courant et/ou de charges de surface.

D'autres caractéristiques et avantages de la présente invention apparaîtront à la lecture de la description suivante d'un mode de réalisation préférentiel de la présente invention, donné à titre explicatif et non limitatif, et des dessins annexés dans lesquels :

- la figure 1 représente un capteur passif standard associé à un intégrateur et à un amplificateur, selon un mode de réalisation connu ;

- la figure 2 représente un mode de réalisation avantageux de la présente invention utilisant un capteur passif standard associé à un intégrateur et à un module de compensation ;

- la figure 3 représente la réponse en fréquence du module de compensation de la figure 2 ;

- la figure 4 représente la caractéristique de transfert d'un autre mode de réalisation de la présente invention ;

- les figures 5 et 6 représentent chacune un exemple de réalisation du dispositif selon la présente invention.

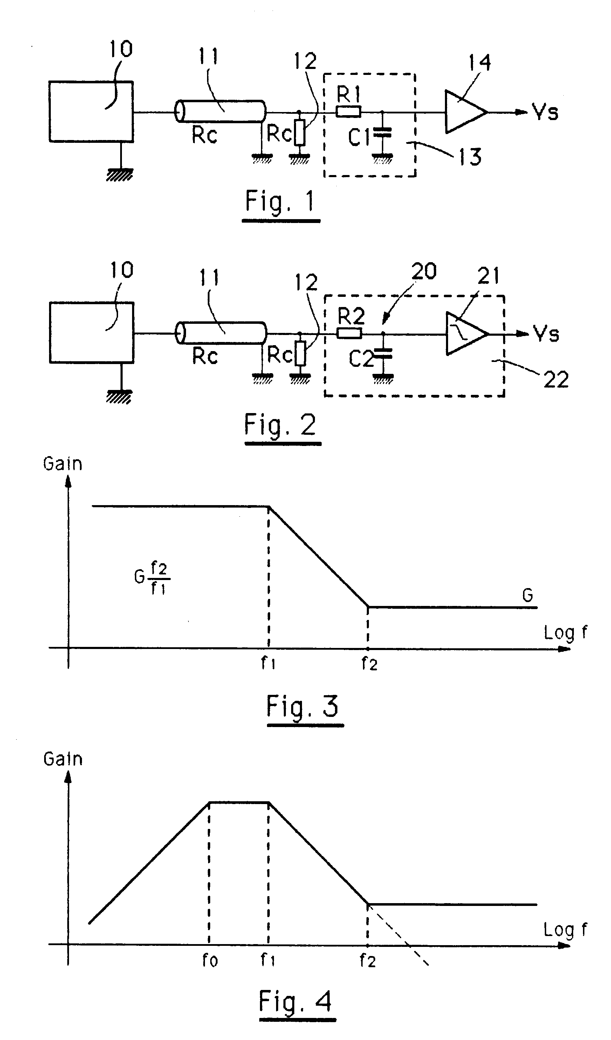

La figure 1 représente un capteur passif standard associé à un intégrateur et à un amplificateur, selon un mode de réalisation connu.

Le mode de réalisation représenté comprend un capteur 10 branché sur une charge 12 d'impédance $R_c$ à travers un câble 11 de même impédance.

Le capteur 10 peut notamment consister en un capteur de champ électrique, de champ magnétique, de courant, de charges de surface ou autres grandeurs dérivées. Il présente une réponse dérivative qu'il est donc nécessaire d'intégrer pour obtenir la valeur mesurée.

A titre d'exemple, pour un capteur de champ électrique, la tension délivrée aux bornes de la charge $R_c$ est de :

$$V = R_c \, Aeq \, \varepsilon_0 \, dE/dt$$

avec:

$R_c$ : impédance de la charge,

Aeq : surface équivalente du capteur,

$\varepsilon_0$ $= 10^{-9}/36\pi$

E : champ électrique

Le signal issu du capteur 10 est intégré par des moyens d'intégration 13, pouvant notamment être constitués d'une cellule $R_1C_1$. L'intégration effectuée permet d'obtenir la valeur du signal mesuré par le capteur dérivatif 10.

Le signal intégré peut être suivi par un amplificateur 14 dont l'impédance d'entrée est grande devant celle de l'intégrateur 13 ($R_{entrée} \gg R_1$).

La tension de sortie $V_s$ de l'amplificateur 14 est donnée par la relation:

$$V_s = GR_cAeq \, \varepsilon_0 \, \frac{dE}{dt} \times \frac{1}{1 + R_1C_1p} \approx GR_c \, Aeq \, \varepsilon_0 \, \frac{dE}{dt}$$

$$\times \frac{1}{R_1C_1p} = GR_c \, Aeq \, \varepsilon_0 \, \frac{E}{\tau_1}$$

avec

$\tau_1 = R_1C_1 =$ constante de temps de l'intégrateur 13,

G = gain de l'amplificateur 14.

Dans le cas d'un capteur de champ magnétique, la relation donnant la tension en sortie de l'amplificateur est :

$$V_s = G \, Aeq \, \mu_0 H / \tau_1$$

avec : H : champ magnétique

$$\mu = 4\pi \times 10^{-7}$$

L'intégration est réalisée à partir de la fréquence $f_1 = 1 / 2\pi R_1C_1$ où $R_1C_1 = \tau_1$

La figure 2 représente un mode de réalisation avantageux de la présente invention utilisant un capteur passif standard associé à un intégrateur et à un module de compensation ;

Un capteur passif standard 10 est relié à une résistance de charge de 12 de valeur $R_c$ à travers un câble 11 d'impédance $R_c$.

Le traitement du signal reçu est assuré par un dispositif 22 comprenant des moyens d'intégration 20 et des moyens de compensation 21.

Les moyens d'intégration 20 pouvant notamment consister en une cellule $R_2C_2$ du type passe-bas. Une des caractéristiques de l'invention est que la constante de temps $\tau_2$ valant $R_2C_2$ est très inférieure à la constante de temps $\tau_1$ du mode de réalisation connu décrit à la figure 1.

On a ainsi :

$$f_2 = 1 /(2\pi R_2 \text{-} C_2) \gg f_1$$

L'intégration à partir de la fréquence $f_2$ supérieure à la fréquence $f_1$ conduit à une sensibilité du dispositif $f_2/f_1$ fois plus importante. La fréquence de coupure basse est cependant passée de $f_1$ à $f_2$ et les signaux provenant du capteur dérivatif 10 ne peuvent plus être intégrés à partir de la fréquence $f_1$.

C'est pourquoi, les moyens d'intégration 20 sont suivis par un amplificateur 21, constituant des moyens de compensation, ayant une réponse particulière, pour compenser la perte de la réponse aux fréquences basses. Bien entendu, l'amplificateur 21 peut également être situé en amont des moyens d'intégration 20.

La figure 3 représente la réponse en fréquence de l'amplificateur 21.

L'amplificateur 21 présente :

- Une réponse plate de gain G. $f_2/f_1$ de 0 à $f_1$.

- Une pente de -6 dB/octave de $f_1$ à $f_2$.

- Une réponse plate de gain G à partir de $f_2$.

Ce système d'intégration avec une constante de temps $\tau_2$ faible suivie d'une compensation des fréquences basses permet un gain considérable en sensibilité sans sacrifier la réponse aux fréquences basses.

Ce gain est dû au fait que l'intégration classique $\tau_1 = R_1 C_1$ (fig. 1) permet d'obtenir une bonne réponse aux fréquences basses au prix d'une diminution notable du signal capteur, alors que la solution proposée permet de gagner un facteur important sur le signal issu du capteur au prix d'une faible augmentation du bruit. En effet, la constante d'intégration $\tau_2$ étant faible, l'amplitude du signal en sortie de l'intégrateur 20 reste élevée jusqu'à $f_2$. Le rapport signal/bruit du dispositif de la figure 2 est donc supérieur à celui du montage de la figure 1.

Cette légère augmentation est produite par l'augmentation du gain dans la zone $f_1$-$f_2$.

Les deux exemples suivants permettent d'apprécier le gain en sensibilité pour un capteur de champ électrique et un capteur de champ magnétique.

Un capteur de champ électrique de surface Aeq $= 10^{-2}m^2$ relié à une résistance de charge $R_c = 50\ \Omega$ est utilisé en combinaison avec un dispositif traitement classique (fig. 1) puis avec un dispositif selon la présente invention (fig. 2).

Les dispositifs de traitement doivent fournir une réponse plate de 100 kHz à 1 GHz.

La solution classique (fig.1) consiste à intégrer le signal provenant du capteur à partir de 100 kHz.

Pour un bruit d'environ 100 µVeff à l'entrée de l'amplificateur 14 de gain G = 1, on a :

$$V_s = R_c\ Aeq\ \varepsilon_0\ E/\tau_c$$

or $\tau_c = 1/\ 2\pi\ f_c$ et donc pour $f_c = 100$ KHz, $\tau_c = 1,6$ µs.

Le bruit à la sortie du dispositif est donc de :

$$E_{bruit} = \frac{V_{bruit} \times \tau_c}{R_c\ Aeq\ \varepsilon_0} = \frac{100 \times 10^{-6} \times 1,6 \times 10^{-6}}{50 \times 10^{-2} \times 10^{-9}/36\ \pi} = 36\ Veff/m$$

Selon l'invention (figure 2), le signal sortant du capteur est intégré à partir de 10 MHz et la compensation est réalisée de 100 kHz à 10 MHz.

Le bruit dans la bande 10 MHz - 1 GHz est inchangé et vaut 100 µVeff.

Le bruit dans la bande 100 kHz - 10 MHz vaut, pour un filtre parfait :

$$100\ µVeff.\ (100\ KHz/1\ GHz)^{\frac{1}{2}} = 1\ µVeff$$

et pour un filtre à - 6dB/octave (premier ordre) :

$$1\ µVeff.\ (\pi/2)^{\frac{1}{2}} = 1,25\ µVeff$$

Ce bruit est amplifié avec un gain supplémentaire de

$$10\ MHz/100\ kHz = 100$$

Il se trouve donc à l'entrée:

$$1,25 \cdot 100 = 125\ µVeff$$

Le bruit total à l'entrée est de:

$$(100^2 + 125^2)^{\frac{1}{2}} = 160\ µVeff$$

Le bruit en champ électrique devient :

$$E_{bruit} = \frac{160 \times 10^{-6} \times 1,6 \times 10^{-6}}{50 \times 10^{-2} \times 10^{-9}/36\ \pi} = 0,58\ Veff/m$$

Le bruit a donc chuté de 36 dB.

Selon un autre mode de mise en oeuvre, un capteur de champ magnétique de surface équivalente

Aeq $= 10^{-3}m^2$ et $R_c = 50\ \Omega$ est utilisé en combinaison avec un dispositif de traitement classique (figure 1) puis en combinaison avec dispositif selon la présente invention (fig.2).

Une réponse plate est souhaitée de 100 kHz à 1 GHz.

La solution classique (fig.1) consiste à intégrer le signal provenant du capteur dérivatif à partir de 100 kHz. Pour un gain unitaire de l'amplificateur 14, la tension de sortie $V_s$ du dispositif vaut :

$$V_s = Aeq\ \mu_0 H/\tau_c\ \text{avec}\ V_{bruit} = 100\ µVeff$$

pour $f_c = 100$ kHz, $\tau_c = 1,6$ µs, d'où:

$$H_{bruit} = \frac{V_{bruit} \times \tau_c}{Aeq\ \mu_0} = \frac{100 \times 10^{-6} \times 1,6 \times 10^{-6}}{10^{-6} \times 4\pi 10^{-7}} = 127\ mA/m$$

Selon l'invention, l'intégration est réalisée à partir de 10 MHz et la compensation de 100 kHz à 10 MHz.

Le bruit total ramené à l'entrée est de 160 µVeff.

$$H_{bruit} = 127\ mAeff \times \frac{160}{100} \times \frac{1}{100} = 2\ mAeff/m$$

Le même gain de sensibilité qu'avec un capteur de champ électrique est obtenu.

La figure 4 représente la réponse en fréquence d'un autre mode de réalisation de la présente invention.

La zone de fréquence 0 à $f_1$ n'est pas utilisée par le dispositif selon l'invention. Elle produit en revanche du bruit qu'il est possible de limiter en plaçant dans la chaîne de traitement un filtre passe-haut de fréquence de coupure $f_0$, avec $f_0$ inférieur à $f_1$. Un tel filtre peut être placé avant ou après les moyens d'intégration 20 (fig.2) ou alors en sortie des moyens de compensation 21.

La fonction de transfert de la figure 4 est celle d'un filtre passe-haut combiné avec les moyens de compensation 21.

Si l'on tient compte également des moyens d'intégration 20, la fonction de transfert est celle représentée en pointillés débutant à $f_2$.

Pour les deux exemples cités précédemment, un filtre passe-haut de fréquence de coupure 75 kHz permet de ramener le bruit basse fréquence de 125 µVeff à : 125 $(25/100)^{\frac{1}{2}}$ = 62,5 µVeff ($f_1$ - $f_0$ = 100 - 75 = 25 kHz) soit un gain de 2,6 dB.

La fonction de transfert représentée à la figure 4 est celle obtenue avec un filtre passe-haut du premier ordre, mais il est bien entendu possible d'utiliser un filtre d'ordre supérieur.

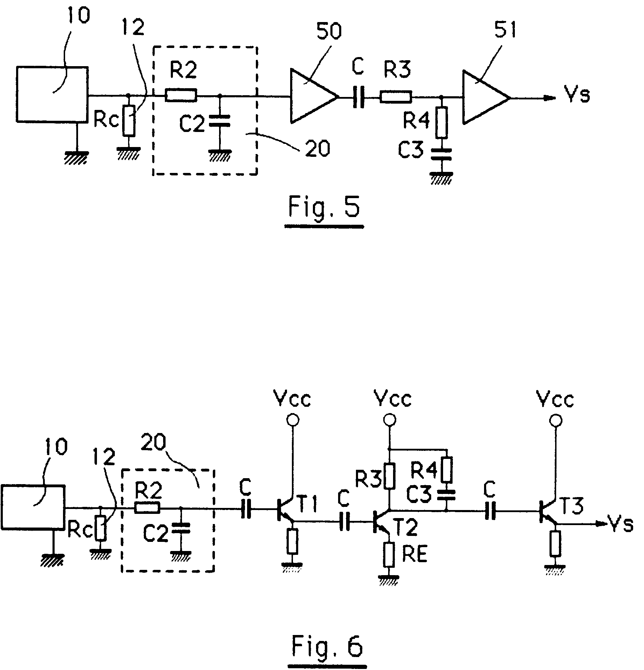

Les figures 5 et 6 représentent chacune un exemple de réalisation du dispositif selon la présente invention.

La figure 5 représente un premier mode de réalisation avantageux du dispositif selon la présente invention.

Le dispositif représenté constitue une chaîne de traitement d'un signal provenant d'un capteur 10 dérivatif. La cellule 20 constitue un intégrateur de fré-

quence de coupure $f_2 = 1/2\pi R_2 C_2$.

La cellule 20 est suivie d'un amplificateur 50 d'impédance d'entrée bien supérieure à l'impédance équivalente de la cellule 20. L'amplificateur 50 présente un gain plus élevé que le rapport $f_2/f_1$.

Un condensateur C branché en série en sortie de l'ampliticateur 50 permet de limiter la bande de fréquence passantes inférieures à $f_1$ et de diminuer ainsi encore le bruit.

Le condensateur C est suivi d'un filtre $R_3 R_4 C_3$ de fonction de transfert:

$$T(p) = R_4(p + \omega_2)/(R_3 + R_4)(p + \omega_1)$$

avec

$$\omega_1 = 1/(R_3 + R_4)C_3 = 2\pi.f_1$$
$$\omega_2 = 1/R_4 C_3 = 2\pi.f_2$$

Il est ainsi possible de régler indépendemment les fréquences de coupure $f_1$ et $f_2$ du filtre.

Le filtre $R_3 R_4 C_3$ est suivi d'un amplificateur 51 présentant une impédance d'entrée bien supérieure à l'impédance équivalente du filtre.

Les amplificateurs 50 et 51 sont avantageusement des amplificateurs large bande, mais tout autre type d'amplificateurs convient également.

La figure 6 représente un autre mode de réalisation avantageux du dispositif selon la présente invention.

Pour des raisons de clarté, les résistances de polarisation des transistors $T_1$ à $T_3$ n'ont pas été représentées.

Les transistors $T_1$ et $T_3$ sont montés en collecteur commun et remplissent ainsi une fonction de suiveur (adaptation d'impédance).

Les moyens de compensation sont constitués par le transistor $T_2$ et par le réseau $R_3 R_4 C_3$.

Le gain du transistor $T_2$ est donné par la relation :

$$Av = \frac{R_3 R_4}{R_3 + R_4} \times \frac{1}{R_E} \frac{p + \dfrac{1}{R_4 C_3}}{p + \dfrac{1}{C_3(R_3 + R_4)}} =$$

$$\frac{R_3 R_4}{(R_3 + R_4)R_E} \frac{p + \omega_2}{p + \omega_1}$$

avec $\omega_1 = 1/C_3(R_3 + R_4)$ et $\omega_2 = 1/(R_4 C_3)$

Les deux condensateurs C permettent de limiter la bande en dessous de $f_1$ et de diminuer ainsi encore le bruit.

Bien entendu, les figures 5 et 6 ne représentent que deux modes de réalisation préférentiels de la présente invention, ce dispositif de traitement du signal issu d'un capteur dérivatif pouvant être réalisé de différentes manières.

De plus, la caractéristique de transfert du dispositif peut présenter des pentes plus importantes, et notamment de - 12 dB/octave.

**Revendications**

1. Dispositif de traitement d'un signal électrique provenant d'un capteur (10) du type dérivatif destiné à mesurer un champ électrique ou magnétique, des courants de charge de surface ou autres grandeurs dérivées, ledit traitement incluant le calcul de la primitive de la partie dudit signal de fréquence spectrale supérieure à une fréquence basse $f_1$ , caractérisé en ce qu'il comprend:
   – des moyens (20) d'intégration électronique dudit signal, à partir d'une fréquence $f_2$ supérieure à ladite fréquence basse $f_1$;
   – des moyens (21) de compensation amplifiant et intégrant ledit signal entre les fréquences $f_1$ et $f_2$.

2. Dispositif selon la revendication 1 caractérisé en ce que lesdits moyens (21) de compensation sont montés en ligne et en aval desdits moyens (20) d'intégration.

3. Dispositif selon l'une quelconque des revendications 1 et 2 caractérisé en ce que lesdits moyens (21) de compensation présentent une pente d'intégration égale à celle desdits moyens (20) d'intégration.

4. Dispositif selon l'une quelconque des revendications 1 à 3 caractérisé en ce que lesdites pentes d'intégration sont de -6dB/octave.

5. Dispositif selon l'une quelconque des revendication 1 à 3 caractérisé en ce que lesdits moyens (20) d'intégration sont constitués chacun par au moins une cellule RC.

6. Dispositif selon l'une quelconque des revendications 1 à 5 caractérisé en ce qu'il comprend également un filtre passe-haut dans ladite chaîne de traitement, de fréquence de coupure $f_0$ inférieure à $f_1$.

7. Dispositif selon la revendication 6 caractérisé en ce que la pente de la caractéristique de transfert dudit filtre passe-haut est de + 6dB/octave.

8. Dispositif selon la revendication 1 caractérisé en ce que ledit capteur (10) du type dérivatif est un capteur passif.

9. Dispositif selon l'une quelconque des revendications 1 et 6 caractérisé en ce que ladite fréquence basse $f_1$ est de l'ordre de 100 kHz et ladite fréquence $f_2$ de l'ordre de 10 MHz.

10. Dispositif selon l'une quelconque des revendications 1 et 2 caractérisé en ce que lesdits moyens de compensation comprennent au moins un amplificateur large bande et/ou au moins un transistor.

11. Utilisation du dispositif selon l'une quelconque des revendications précédentes pour le traitement de signaux provenant d'un capteur de champ électrique, de champ magnétique, de courant et/ou de charges de surface.

Fig. 1

Fig. 2

Fig. 3

Fig. 4

Fig. 5

Fig. 6

**Office européen des brevets**

# RAPPORT DE RECHERCHE EUROPEENNE

Numero de la demande

EP 91 40 2466

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | FR-A-2 352 304 (SOCIETE NATIONALE INDUSTRIELLE AEROSPATIALE) * Page 5, lignes 7-20; figure 1 * | 1,2 | G 01 R 29/08 G 01 R 15/10 |
| A | --- | 5,8,11 | |
| Y | EP-A-0 068 394 (SIEMENS) * Abrégé; figure 1 * | 1,2 | |
| A | --- | 10 | |
| A | FR-A-2 194 081 (RCA CORP.) * Page 1, lignes 10-15; page 5, ligne 36 - page 6, ligne 39; figure 1 * --- | 1,5 | |
| A | RADIO FERNSEHEN ELEKTRONIK, vol. 25, no. 15, 1976, pages 488-490, VEB Verlag Technik, Berlin, DD; J. EGGERT et al.: "NFM1 - ein aperiodisches Nahfeldstärke-messgerät für Messungen an Hochfrequenzarbeitsplätzen" * Page 489, colonne de gauche, alinéa 6 - colonne du milieu, alinéa 2; page 490, colonne de gauche, dernier alinéa; figure 1 * --- | 1,9 | |
| | | | **DOMAINES TECHNIQUES RECHERCHES (Int. Cl.5)** |
| A | EP-A-0 149 319 (MARCONI) * Abrégé; page 2, lignes 15-20; page 5, lignes 5-12; figure 1 * ----- | 1,10 | G 01 R H 03 F |

Le présent rapport a été établi pour toutes les revendications

| Lieu de la recherche | Date d'achèvement de la recherche | Examinateur |
|---|---|---|
| LA HAYE | 09-12-1991 | SINAPIUS G.H. |